(19) Europäisches Patentamt
European Patent Office
Office européen des brevets

(11) **EP 4 127 786 B1**

(12) **FASCICULE DE BREVET EUROPEEN**

(45) Date de publication et mention
de la délivrance du brevet:
**08.01.2025 Bulletin 2025/02**

(21) Numéro de dépôt: **21716417.7**

(22) Date de dépôt: **02.04.2021**

(51) Classification Internationale des Brevets (IPC):
**G02B 1/12** *(2006.01)*      **G02B 5/08** *(2006.01)*
**C23C 14/02** *(2006.01)*      **G02C 7/10** *(2006.01)*
**G02C 7/06** *(2006.01)*      **G02B 5/28** *(2006.01)*
**C23C 14/58** *(2006.01)*

(52) Classification Coopérative des Brevets (CPC):
**G02B 1/12; C23C 14/5833; C23C 14/5873;
G02B 5/286; G02B 5/287; G02C 7/107**

(86) Numéro de dépôt international:
**PCT/EP2021/058793**

(87) Numéro de publication internationale:
**WO 2021/198507 (07.10.2021 Gazette 2021/40)**

(54) **PROCÉDÉ DE TRAITEMENT D'UN ARTICLE OPTIQUE MIROITÉ**

VERFAHREN ZUR BEHANDLUNG EINES GESPIEGELTEN OPTISCHEN ELEMENTS

METHOD FOR TREATING A MIRRORED OPTICAL ITEM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **02.04.2020 FR 2003316**

(43) Date de publication de la demande:
**08.02.2023 Bulletin 2023/06**

(73) Titulaire: **BNL Eurolens
01200 Montanges (FR)**

(72) Inventeurs:
• **ESTEVEZ RODRIGUEZ, Vicente
01200 Bellegarde Sur Valserine (FR)**
• **LE BIHAN, Laure
01200 Bellegarde Sur Valserine (FR)**

(74) Mandataire: **Innovincia
11, avenue des Tilleuls
74200 Thonon-Les-Bains (FR)**

(56) Documents cités:
EP-A1- 3 293 565      EP-B1- 2 374 032
WO-A1-2018/015650      DE-A1- 102011 119 598
US-A1- 2003 129 417      US-A1- 2005 084 626
US-A1- 2019 250 309      US-A1- 2019 302 697

## Description

L'invention se situe dans le domaine de traitement des verres ophtalmiques miroités notamment revêtus d'un revêtement interférentiel multicouche Par verre ophtalmique, on entend selon l'invention une lentille, correctrice ou non, qui peut être utilisée comme un verre de lunette, par exemple pour des lunettes, en particulier des lunettes de soleil ou des masques ou analogues.

De nos jours, les verres ophtalmiques et plus spécifiques des verres solaires n'ont pas seulement des effets de protection de l'oeil du soleil, mais présentent aussi un aspect esthétique important pour le porteur de ces articles optiques.

Ainsi, le porteur de lunettes souhaite par exemple des articles optiques personnalisés qui permettent de se distinguer par leurs aspects extérieurs, notamment l'apparence en termes de coloration et de réflexion.

Or, comme cela est souvent le cas en industrie, la personnalisation augmente fortement le coût de revient des articles produits et s'oppose généralement à une production standardisée à moindre coût de revient.

Dans le présent cas, un verre ophtalmique miroité, c'est-à-dire présentant un revêtement interférentiel multicouche, présente un aspect externe uniforme.

Pour personnaliser un tel article optique, on pourrait par exemple penser à modifier dans certaines zones l'épaisseur d'une ou de plusieurs couches du revêtement interférentiel multicouche en utilisant un masque par tampographie en silicone. Toutefois, un tel procédé manque de précision au niveau des contours (problème de bavures) et au niveau de la répétabilité. De plus, on constate des problèmes d'adhésion des couches ultérieurement déposées sur des zones tamponnées et donc une augmentation du taux de rebuts.

La gravure par laser de certaines couches du revêtement interférentiel multicouche paraît par la suite comme une alternative séduisante. Toutefois, cette gravure laser peut générer des microfissures au niveau de l'article optique qui altèrent la durée de vie de l'article optique. De plus, une telle gravure n'est pas réalisée sous une atmosphère contrôlée et des particules peuvent se déposer sur l'article optique ainsi traité conduisant par la suite à des défauts d'aspect et l'adhésion par exemple d'un traitement antisalissure peut ne plus être réalisée avec succès.

Le document WO2018015650 décrit un procédé de marquage d'article optique dans lequel on utilise une ablation par laser. DE10 2011 119598 décrit un procédé de dépôt multicouche.

On connaît également l'enlèvement d'une partie de couche par bombardement ionique, voir par exemple US 2005/084626 et US 2019/302697.

La présente invention a donc pour objet de palier au moins partiellement aux inconvénients précités en proposant un procédé de traitement défini par les caractéristiques de la revendication 1.

Ainsi, à partir d'une production standardisée, il est possible de personnaliser une lentille ophtalmique miroitée de façon très précis et répétable

Le procédé selon l'invention peut présenter un ou plusieurs des aspects suivants pris seuls ou en combinaison :
Lors de l'étape d'enlèvement par bombardement ionique, l'épaisseur initiale de la couche interférentielle éloignée peut être réduite d'une valeur inférieure à son épaisseur initiale.

L'empilement de miroitage comporte par exemple deux (exactement deux) ou au moins trois couches interférentielles, et la réduction d'épaisseur de la couche interférentielle éloignée est par exemple déterminée de façon à ce qu'entre la première et la seconde coloration, la différence de l'angle de teinte est inférieure à 2% et la différence de la chromacité est supérieure à 10%.

La différence de brillance entre la première et la seconde coloration est notamment inférieure à 10%, et plus particulièrement inférieure à 5%.

Le rapport b*/a* de l'espace CIELAB peut être constant dans la limite d'une tolérance de 10%, notamment 5%.

La réduction d'épaisseur peut être uniforme dans chacune des zones prédéterminées.

On peut prévoir que l'étape d'enlèvement par bombardement ionique est précédée d'une étape de détermination d'une durée de bombardement ionique pour obtenir la seconde coloration dans la première zone prédéterminée.

L'étape d'enlèvement par bombardement ionique est notamment telle que l'article optique miroité présente par un phénomène d'interférométrie un miroitage ayant une intensité de réflexion dans la première zone prédéterminée différente d'une zone non traitée par le bombardement ionique.

L'article miroité peut comprendre ladite première zone prédéterminée et une zone non traitée par le bombardement ionique, l'une des deux zones correspondant à une zone de vision de près avec un miroitage ayant une intensité de réflexion plus faible que dans l'autre zone correspondant à une vision de loin.

La surface de la première zone prédéterminée est par exemple plus petite que la surface de l'article optique miroité et le procédé peut comporter en outre une deuxième étape d'enlèvement (étape d'enlèvement supplémentaire) par bombardement ionique au moins dans une deuxième zone prédéterminée de l'article optique miroité qui est différente de la première zone prédéterminée, lors de la deuxième étape d'enlèvement une deuxième épaisseur prédéfinie de la couche interférentielle éloigné est enlevée qui est inférieure à la première épaisseur initiale de cette couche interférentielle éloignée et différente de l'épaisseur enlevée lors de la première étape d'enlèvement, dans la deuxième zone prédéterminée, l'article optique miroité présentant par un phénomène d'interférométrie une troisième coloration selon l'espace CIELAB différente de la première et de la deuxième coloration selon l'espace CIELAB.

On peut réaliser l'étape d'enlèvement par bombardement ionique dans un box-coater équipé d'un canon à ions.

On dispose en particulier un masque entre l'article optique miroité et le canon à ions empêchant les ions à parvenir aux couches interférentielles en dehors de la zone prédéterminée.

Le masque comprend notamment un adhésif apposé sur l'article optique miroité.

Le masque peut comprendre un cache, notamment métallique disposé entre le canon à ions et l'article optique miroité.

On peut réaliser le bombardement ionique sous vide, ou dans une atmosphère contenant un gaz inerte ayant une pression inférieure ou égale à la pression atmosphérique.

Après l'étape d'enlèvement par bombardement ionique, on applique notamment un traitement antisalissure sur l'ensemble de l'article optique miroité.

L'invention concerne également une lentille ophtalmique miroitée obtenue avec un procédé présenté ci-dessus et présentant au moins deux colorations différentes selon l'espace CIELAB. L'article miroité comprend en particulier ladite première zone prédéterminée et une zone non traitée par le bombardement ionique, l'une des deux zones correspondant à une zone de vision de près avec un miroitage ayant une intensité de réflexion plus faible que dans l'autre zone correspondant à une vision de loin.

D'autres caractéristiques et avantages de l'invention apparaîtront plus clairement à la lecture de la description suivante, donnée à titre d'exemple illustratif et non limitatif, et des dessins annexés parmi lesquels :

[Fig 1A] la figure 1A montre de façon schématique un article optique miroité,

[Fig 1B] la figure 1B montre un éclaté selon l'axe de l'article miroité de la figure 1A, séparant artificiellement les différentes couches formant l'article miroité,

[Fig 2] la figure 2 montre schématiquement un empilement de couches d'un article optique miroité des figures 1A et 1B selon un premier mode de réalisation,

[Fig 3] la figure 3 montre schématiquement un empilement de couches d'un article miroité selon un deuxième mode de réalisation,

[Fig 4] la figure 4 montre l'article optique miroité de face selon les exemples des modes de réalisation des figures 1A, 1B, 2 et 3,

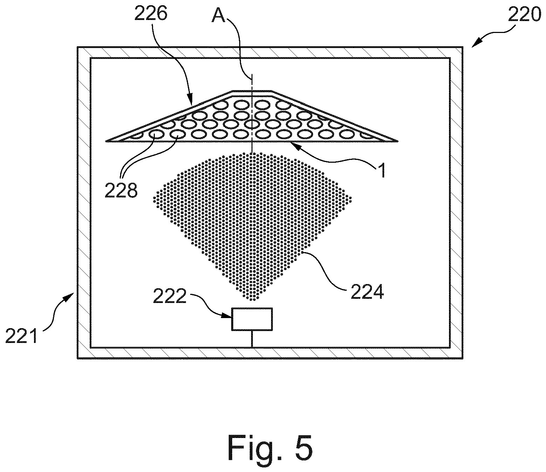

[Fig 5] la figure 5 est un schéma simplifié de côté, partiellement en coupe transversale d'une enceinte de traitement qui est susceptible d'être mise en oeuvre pour le traitement d'articles optiques miroités,

[Fig 6] la figure 6 montre un organigramme d'un exemple de réalisation du procédé de traitement des articles optiques miroités,

[Fig 7] la figure 7 est une première variante de la figure 4,

[Fig 8] la figure 8 est une deuxième variante de la figure 4,

[Fig 9] la figure 9 est une troisième variante de la figure 4, et

[Fig 10] la figure 10 montre selon un exemple la réflectivité d'une zone d'un article optique miroité avant et après la réalisation du procédé de traitement.

On va maintenant décrire un exemple d'un mode de réalisation en référence aux figures. Sur toutes les figures, les mêmes références se rapportent aux mêmes éléments.

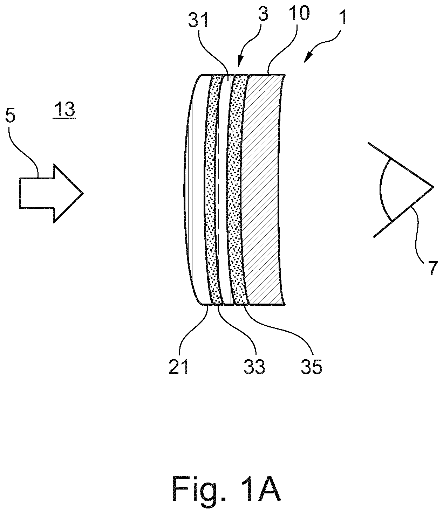

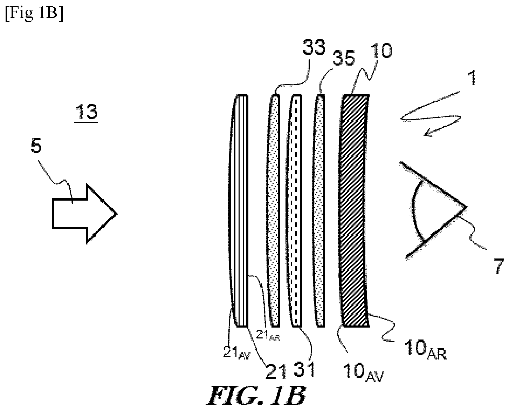

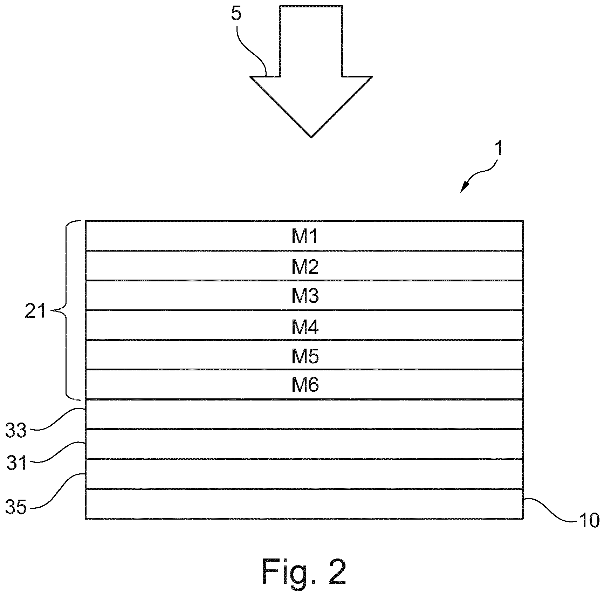

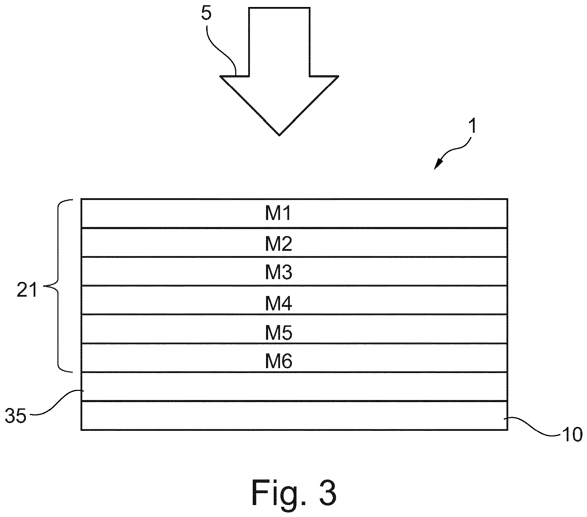

Ainsi, à partir des exemples de schémas d'empilements de couches des figures 2 ou 3, on peut facilement déduire des figures similaires aux figures 1A et 1B en y ajoutant ou enlevant différentes couches.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées pour fournir d'autres réalisations.

Par face « avant » ou face « arrière » d'une couche, on se réfère à la propagation des rayons de lumière vers l'œil. Ainsi une face « avant » est toujours celle qui est la plus proche du champ de vision de l'utilisateur et une face « arrière » est toujours celle qui est la plus proche de l'oeil de l'utilisateur.

Par « amont » ou « aval » de deux éléments ou couches, on se réfère à la propagation des rayons de lumière vers l'œil. Ainsi un premier élément est disposé en « amont » d'un second élément lorsque la lumière traverse sur son chemin vers l'œil de l'utilisateur d'abord le premier élément, puis le second élément. A contrario, un premier élément est disposé en « aval » d'un second élément lorsque la lumière traverse sur son chemin vers l'oeil de l'utilisateur d'abord le second élément, puis le premier élément.

Dans le présent exposé, le domaine UV des ultraviolets comprend les longueurs d'onde inférieures à 380nm.

Dans le présent exposé, le domaine visible comprend les longueurs d'onde comprises entre environ 380nm et environ 800nm, et notamment les longueurs d'ondes comprises entre environ 400nm et 750nm.

La réflectivité est définie par le facteur moyen de réflexion lumineuse $\rho v$ dans le domaine visible tel que défini dans la norme ISO 12311:2013 point 7.7 :

La valeur de py en pourcentage est calculée par le rapport du flux lumineux réfléchi par le filtre $\Phi_R$ au flux incident $\Phi_I$ comme suit:

$$\rho_V = 100 \times \frac{I_R}{I_I} = 100 \times \frac{\int_{380}^{780} \rho(\lambda) \cdot V(\lambda) \cdot S_{D65}(\lambda) \cdot d\lambda}{\int_{380}^{780} V(\lambda) \cdot S_{D65}(\lambda) \cdot d\lambda}$$

où

$\grave{a}$     est la longueur d'onde en nanomètres;

$\rho(\lambda)$     est le facteur de réflexion spectrale du filtre à la longueur d'onde $\lambda$;

$V(\lambda)$     est la sensibilité relative de l'oeil humain, telle que définie dans l'ISO 11664-1;

$S_{D65}(\lambda)$     est la répartition de l'énergie spectrale de l'illuminant normalisé D65 de la CIE, tel que défini dans l'ISO 11664-2.

L'angle de teinte et la chromacité sont définis par la norme NF ISO 11664-4 :2011-07 point 4.2

Soit a* et b* les coordonnées colorimétriques CIELAB.

La chromacité est défini par

$$C^*_{ab} = [(a^*)^2 + (b^*)^2]1/2$$

L'angle de teinte $h_{ab}$ = arctan (b*/a*)

L'angle de teinte doit être compris entre 0° et 90° si a* et b* sont tous deux positifs, entre 90° et 180° si b* est positif et a* négatif, entre 180° et 270° si b* et a* sont tous deux négatifs et entre 270° et 360° si b* est négatif et a* positif.

La brillance est définie par le calcul BYK .

On utilise aussi le terme « l'intensité de réflexion » est définie par ou équivalent du facteur moyen de réflexion lumineuse tel que défini ci-dessus.

L'article optique miroité 1 des figures 1A et 1B est selon l'invention destiné à être utilisé, notamment comme lentille ophtalmique, pour des lunettes, en particulier des lunettes de soleil, ou des masques. Pour ce faire il est seulement nécessaire de façonner le bord externe 3 selon la forme voulue du cadre d'une monture ou d'un masque.

Sur les figures 1A et 1B, on a représenté par la flèche 5 la lumière incidente sur l'article miroité 1 et un oeil 7 pour représenter un utilisateur. Le champ de vision 13 se situe donc du côté de la flèche 7 et l'utilisateur regarde au travers l'article optique miroité 1 par son œil 7

Par article miroité 1, on entend selon l'invention une lentille ophtalmique, correctrice ou non, finie ou semi-finie, apte à être montée dans une monture, par exemple une monture de lunettes, un masque ou une visière destinée à être placée devant les yeux et formant un écran de protection visuel. L'article optique miroité 1 est le produit de départ qui sera soumis au procédé qui sera décrit par la suite.

L'article optique miroité 1 peut être en verre minéral ou en verre organique ou une combinaison des deux

L'article optique miroité 1 peut être teinté ou non, ou présenter un gradient de teinte, et il peut comprendre d'autre fonctions solaires comme une fonction polarisante, photochromique seule ou en combinaison comme on le verra plus loin. L'article miroité est par exemple de classe 2, 3 ou 4 selon la norme ISO 12312.

Il peut également comprendre d'autres fonctions supplémentaires, seules ou en combinaison parmi la liste non exhaustive suivante : antichoc, anti-rayures, anti-abrasion, anti-reflet, anti-salissures, anti-buée, anti-statique. Ces fonctions supplémentaires peuvent être réalisées selon des méthodes classiques (trempage, dépôt sous vide, dépôt à la tournette (« spin coating »), dépôt par pulvérisation (« spray coating »)...).

En référence aux figures 1A et 1B, l'article optique miroité 1 comprend un substrat 10 transparent.

Ce substrat 10 transparent présente une face arrière 10AR destinée à être orientée vers l'oeil 7 de l'utilisateur, destinée à former la surface externe arrière d'article miroité 1 orientée vers l'oeil de l'utilisateur, et une face avant 10AV orientée vers le champ de vision 13 de l'utilisateur.

Par transparent, on entend une couche laissant passer la lumière incidente en totalité ou au moins partiellement. Le substrat 10 transparent peut être teinté, c'est-à-dire par exemple inclure des colorants et/ou des pigments, ou non.

Plus généralement, le ou les matériaux de certaines couches de l'article optique miroité 1 peuvent être en n'importe quel matériau couramment utilisé dans le domaine de l'optique et en particulier dans le domaine ophtalmique.

Comme matériau thermoplastique, on peut par exemple choisir dans le groupe non exhaustif suivant : polymethyl(meth)acrylate, polycarbonate, polycarbonate/polyester mélangés, polyamide, polyester, cyclic olefin copolymers, polyuréthane, polysulfone, du TAC (triacétate de cellulose), polyimide , polyuréthanes ; poly (téréphtalate d'éthylène) et le polyméthacrylate de méthyle (PMMA). et copolymères et leur combinaison.

Comme matériau thermodurcissable, on peut par exemple choisir dans le groupe non exhaustif suivant du CAB (cellulose acétate butyrate), les copolymères éthylène/norbornène ou éthylène/cyclopentadiène ; (homo et copolymères de carbonates allylique de polyols aliphatiques ou aromatiques linéaires ou ramifiés, comme les homopolymères de diéthylène glycol bis(carbonate d' allyl) (CR 39®) ; (homo et copolymères d'acide methacrylique et les esters, qui peuvent être dérivés de bisphénol A ; (polymères et copolymères de l'acide thiomethacrylique et esters, (polymères et copolymères d'uréthane et de thiouréthane), ( polymères et copolymères d'epoxy), (polymères et copolymères de sulfures et d'épisulfures) et leurs combinaisons.

Pour colorer le matériau thermoplastique, il est possible d'ajouter des pigments ou des colorants. Concernant les pigments, ceux-ci peuvent être des pigments organiques ou minéraux.

Le matériau du substrat 10 est par exemple choisi parmi le groupe des matériaux suivants : polymethyl(meth)acrylate, polycarbonate, polycarbonate/polyester mélangés, polyamide, polyester, cyclic olefin copolymers, polyuréthane, polysulfone, du TAC (triacétate de cellulose) ou de la cellulose acétate butyrate et leur combinaison.

Le fait que la face arrière 10AR forme une face externe n'empêche pas qu'elle soit traitée par exemple par un traitement anti-rayure et/ou antisalissure et/ou anti-reflet en face arrière.

En amont du substrat 10 est disposé un empilement de miroitage 21.

Selon le mode de réalisation des figures 1A, 1B et 2, un ensemble polarisant 31 comprenant par exemple un film polariseur notamment de polyvinyle alcool (PVA) dopé d'iode et étiré axialement connu pour ses propriétés polarisantes, peut être disposé entre l'empilement de miroitage 21 d'une part et le substrat 10 d'autre part et fixé à ceux-ci par l'intermédiaire de couches de colle 33 et 35. Dans l'ensemble polarisant 31, le film polariseur peut être pris en sandwich par deux couches minces, notamment en matériau thermoplastique notamment pour protéger le film polariseur. L'ensemble polarisant 31 peut aussi être formé par un film polariseur uniquement.

L'ensemble polarisant 31 est collé à la face arrière 21AR de l'empilement de miroitage 21 et à la face avant 10AV du substrat 10.

Selon une première variante non représentée, une couche d'adhésion est disposée entre l'ensemble polarisant 31 et le substrat 10.

Selon une deuxième variante non représentée, une couche de traitement anti-rayure est disposée entre l'ensemble polarisant 31 et l'empilement de miroitage 21.

Par ailleurs, un vernis peut être disposé sur l'ensemble polarisant 31, de sorte que le vernis se trouve entre l'ensemble polarisant 31 et l'empilement de miroitage 21.

Si dans l'ensemble polarisant 31, le film polariseur est pris en sandwich par deux couches minces, notamment en matériau thermoplastique, la couche la plus en aval peut également servir de couche d'adhésion tel que décrit ci-dessus.

L'empilement de miroitage 21 est plus détaillé sur la figure 2. Il comporte par exemple une succession de couches minces M1, M2, M3, M4, M5 et M6. Les couches minces adjacentes ont un indice de réfraction différent l'une par rapport à l'autre. Cependant deux couches minces non adjacentes peuvent avoir des indices de réfraction identiques entre eux.

La couche M1 est la couche interférentielle qui est éloignée du substrat 10 avec une première épaisseur initiale $e_{1\text{-init}}$ et un premier indice de réfraction $n_1$.

Les couches M2 à M6 sont des couches interférentielles rapprochées, disposées entre le substrat 10 et la couche interférentielle éloignée M1, chacune avec une épaisseur initiale $e_{j\text{-init}}$ et un indice de réfraction $n_j$ (j étant un nombre entier de 2 à 6 dans le présent exemple). En particulier la couche M2 présente une seconde épaisseur initiale $e_{2\text{-init}}$ et un indice de réfraction $n_2$ qui est différent du premier indice de réfraction $n_1$.

L'empilement de miroitage 21 donne par un phénomène d'interférométrie une première coloration selon l'espace CIELAB à l'article optique miroité 1, bien entendu en coopération avec les couches se trouvant plus en aval en direction de l'oeil de l'utilisateur 7. Le nombre, les indices et épaisseurs des couches de l'empilement sont prédéterminées expérimentalement, par calcul ou au moyen d'un calculateur ou simulateur de façon à obtenir ladite première coloration avec un taux de réflexion prédéterminé.

Bien entendu le nombre de couches minces $M_j$ peut varier et comporter par exemple que deux, quatre ou huit couches.

Les premières couches minces M1, M3 et M5 sont par exemple réalisées en silice (SiO2) et les deuxièmes couches minces M2, M4 et M6 sont par exemple réalisées en oxyde de titane ($Ti_3O_5$).

D'autres matériaux peuvent être choisis, par exemple de manière que dans le domaine visible, les premières couches minces M1, M3 et M5 ont un premier indice de réfraction $n_1$ inférieur ou égal à 1.5, et les deuxièmes couches minces M2, M4 et M6 ont un deuxième indice de réfraction $n_2$ supérieur à 2 notamment égal ou supérieur à 2.3.

De façon générale les premières couches minces M1, M3 et M5 possèdent une épaisseur comprise entre 70nm et 250nm, et les deuxièmes couches minces M2, M4 et M6 ont une épaisseur comprise entre 40nm et 80nm.

Selon un exemple très concret l'empilement de miroitage 21 est formé de la façon suivante :

| Couche mince | Matériaux | Epaisseur $e_j$ (nm) |
|---|---|---|
| M1 | $SiO_2$ | 76,38 |
| M2 | $Ti_2O_3$ | 58,21 |
| M3 | $SiO_2$ | 169,72 |
| M4 | $Ti_2O_3$ | 61,57 |
| M5 | $SiO_2$ | 165,73 |
| M6 | $Ti_2O_3$ | 71,86 |

Comme on peut le voir sur la figure 2, les premières couches minces M1, M3 et M5 et les deuxièmes couches minces M2, M4 et M6 sont donc disposés en alternance.

L'empilement miroitage 21 est typiquement réalisé par dépôt sous vide de couches minces dans un « box-coater » (installation de déposition d'un revêtement par couches en français).

Il en résulte qu'un ensemble polarisant 31 comprenant par exemple un film polariseur est collé à la deuxième couche mince M6 et à la face avant 10AV de du substrat 10.

Le mode de réalisation de la figure 3 se distingue seulement de celui de la figure 2 par le fait que ce mode de réalisation ne prévoit pas d'ensemble polariseur 31. Le substrat 10 est alors fixé en aval de la face arrière 21AR de l'empilement de miroitage 21.

On peut prévoir la fixation du substrat 10 sur la face arrière 21AR de l'empilement de miroitage 21 par une colle 35.

Selon une variante non représentée, une couche d'adhésion notamment en matériau thermoplastique, peut être disposée entre l'empilement de miroitage 21 et le substrat 10.

Selon encore un autre mode de réalisation non représenté, on peut prévoir que l'ensemble polarisant 31 est remplacé par une couche photochromique activable dans le domaine UV et/ou dans le domaine visible.

Cette couche photochromique peut être un matériau thermoplastique comprenant un colorant photochrome connu. On citera simplement à titre d'exemples les familles suivantes utilisées couramment dans des lentilles ophtalmiques : les spiro-oxazines, les spiroindoline[2,3']benzoxazines, les chromènes, les spiroxazine homo-aza-adamantanes, les spirofluorène-(2H)-benzopyranes, les naphto[2,1-b]pyranes et les naphto[1,2-b]pyranes.

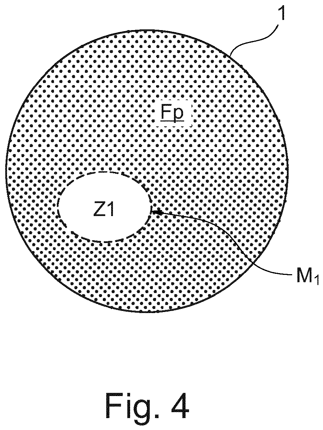

La figure 4 montre l'article optique miroité 1 de face selon les exemples des modes de réalisation des figures précédentes, c'est-à-dire selon la flèche 5.

Sur cette figure est dessinée en traits pointillés une première zone Z1 sur laquelle le traitement du procédé selon l'invention va être appliqué. Dans le présent exemple, la zone Z1 est plus petite que la superficie de l'article optique miroité 1. Son extension est donc plus petite que le diamètre de l'article optique miroité 1.

Les zones / la zone non traitée(s) qui se situent en dehors de la première zone Z1, sont protégée(s) par exemple au moins un film adhésif Fp de protection appliqué sur la couche mince M1 avant la réalisation du procédé de traitement. Ainsi, on voit sur cette figure 4 le film de protection Fp et la couche M1 de l'empilement de miroitage 21 dans la zone Z1. Selon un autre exemple, la zone Z1 couvre l'ensemble de l'article miroité 1 qui va donc, suite au procédé de traitement changer d'aspect extérieur et notamment de coloration. Selon encore un autre exemple, on peut prévoir plusieurs zones par exemple Z1, Z2 etc. comme on le verra plus loin.

Pour cela l'article optique miroité 1 est placé par exemple dans une installation 220 de traitement par bombardement ionique d'articles optiques miroités 1.

Cette installation 220 comprend une enceinte de traitement 221 et une source 222 émettrice d'ions pour bombarder les articles optiques miroités 1 selon un cône d'évaporation 224 par exemple.

L'enceinte de traitement 221 peut être fermée hermétiquement et être reliée à une unité de vide (non représentée), par exemple une pompe à vide, pour baisser la pression à l'intérieur de l'enceinte de traitement 221 à une pression adaptée pour le traitement à appliquer, typiquement par exemple de l'ordre de $3 * 10^{-5}$ mbar.

De façon alternative, le bombardement ionique peut être réalisé dans une atmosphère contenant un gaz inerte ayant une pression inférieure ou égale à la pression atmosphérique. La source émettrice 222 est par exemple constituée par un canon à ions ou un support sur lequel est disposé un matériau à évaporer, source d'ions ou un générateur de plasma, par exemple un creuset ou une platine, et, pour son évaporation, le matériau est par exemple soumis à un échauffement par effet Joule, à un bombardement électronique, ou à un effet de pulvérisation cathodique. La source d'ions peut être un filament en tungstène formant cathode. Le diffuseur de gaz ou générateur de plasma peut être formé par une anode en graphite. Dans ce cas, un creuset ou une platine ne sont pas nécessaire pour une telle source émettrice 222.

Au-dessus de la source émettrice 222 est disposé un support rotatif 226 des articles optiques miroités 1.

A cet effet, le support rotatif 226 comporte des logements individuels 228 des articles optiques miroités 10.

Les logements individuels 228 sont disposés par exemple sur des pistes concentriques.

On comprend qu'en rotation du support 226, chacun des logements individuels 228 réalise des tours de révolution.

Le support rotatif 226 possède par exemple une forme concave ou plus spécifiquement en forme de calotte sphérique de sorte que les logements individuels 228 des articles optiques miroités 1 sont disposés à égale distance de la source émettrice d'ions 222.

Le support rotatif 226 peut tourner autour d'un axe A qui correspond à l'axe de symétrie du support rotatif et passe par le centre de celui-ci ce qui permet d'uniformiser l'exposition des articles optiques miroités au bombardement ionique.

L'installation 220 est par exemple un « box-coater » (installation de déposition d'un revêtement par couches en français) équipé entre autre d'un canon à ions et qui permet aussi appliquer d'autres traitements, notamment des traitements de finition de l'article optique miroité 1, comme un traitement antisalissure. Comme évoqué ci-dessus, le box-coater peut aussi être utilisé pour la réalisation de l'empilement de miroitage 21.

L'installation 220 permet donc dans une même machine la réalisation de diverses étapes dans la fabrication d'un article optique en particulier même certaines qui sont antérieures à celles concernées par le procédé de l'invention.

Avant être introduit dans l'installation 220, la /les zone(s) de l'article optique miroité 1 qui ne doivent pas être traitée(s), sont donc protégée(s) par un cache, par exemple le film adhésif Fp.

De façon alternative, à la place du film de protection Fp, on peut prévoir dans l'installation 220 un masque, en particulier un cache, notamment métallique, entre l'article optique miroité 1 et le canon à ions empêchant les ions à parvenir aux couches interférentielle en dehors de la zone prédéterminée Z1.

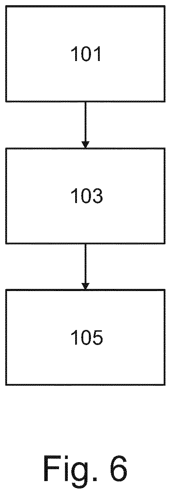

Le procédé comporte une première étape 103 (voir figure 6) consistant à enlever par bombardement ionique au moins dans une première zone prédéterminée Z1 une épaisseur et de l'empilement miroité 21 qui est inférieure à la somme des épaisseurs initiales concernées par l'étape d'enlèvement.

Plus spécifiquement, le procédé de traitement vise à enlever une couche mince $M_j$ que partiellement et le cas échéant complètement la ou les couches minces $M_1$ à $M_{j-1}$ les plus éloignés du substrat 10. Dans le référentiel de la présente demande pour i<j, la couche $M_i$ est plus éloignée du substrat 10 que la couche $M_j$.

Par exemple selon un premier mode de réalisation, l'installation 220 est configurée pour enlever de la couche mince M1 une épaisseur et $< e_{1\text{-init}}$, c'est-à-dire l'épaisseur initiale $e_{l\text{-init}}$ de la couche interférentielle éloignée M1 est réduite d'une valeur et inférieure à son épaisseur initiale $e_{1\text{-init}}$. On aboutit donc à une épaisseur résiduelle de la couche M1 $e_r = e_{l\text{-init}} - e_t$. Cet exemple sera généralement le plus pertinent dans le cas où l'empilement de miroitage 21 possède deux ou plus que trois couches minces interférentielles $M_j$.

Plus généralement si une partie de la couche $M_k$ (k étant un entier, dans le présent exemple k=1 à 6, de préférence k=1 ou 2) est enlevée, on enlève par bombardement ionique dans la zone prédéterminée Z1 une épaisseur :

$$e_t < \sum_{j=1}^{j=k} e_{j-init}$$

La couche Mk possédera donc une épaisseur résiduelle

$$e_r = e_{k-init} - e_t + \sum_{j=1}^{j=k-1} e_{j-init}$$

Par exemple, on peut prévoir que l'épaisseur résiduelle $e_r$ de la couche Mk est comprise dans la plage $0.05\, e_{k\text{-init}} < e_r < 0.95\, e_{k\text{-init}}$.

Ainsi, l'article optique miroité 1, présente dans cette zone prédéterminée Z1 par un phénomène d'interférométrie une deuxième coloration selon l'espace CIELAB différente de la première coloration de l'article optique miroité 1 non traité ou des zones non traitées de l'article miroité 1.

L'avantage de procéder ainsi consiste dans la précision du procédé pour enlever une certaine épaisseur et la répétabilité à l'échelle industrielle, ce qui permet donc d'obtenir un résultat en termes de deuxième coloration prévisible et de bonne qualité.

Selon un exemple, dans le cas où l'empilement de miroitage 21 comporte au moins trois couches interférentielles (comme par exemple selon l'exemple des figures 2 et 3), et le bombardement ionique enlève seulement une partie de la couche mince M1, la réduction d'épaisseur et de la couche interférentielle éloignée M1 est déterminée de façon à ce qu'entre la première et la seconde coloration, la différence de l'angle de teinte est inférieure à 2% et la différence de la chromacité est supérieure à 10%.

Selon un autre exemple la réduction d'épaisseur et de la couche interférentielle éloignée M1 est déterminée de façon à ce que la différence de brillance entre la première et la seconde coloration est inférieure à 10%, notamment inférieur à 5%.

Selon encore un autre exemple, la réduction d'épaisseur et de la couche interférentielle éloignée M1 est déterminée de façon à ce que le rapport b*/a* de l'espace CIELAB est constant dans la limite d'une tolérance de 10%, notamment 5% entre la première et la deuxième coloration.

Après cette première étape 103, on constate que la réduction d'épaisseur est uniforme dans la ou dans chacune des zones Zi prédéterminées.

Selon une variante, l'étape 103 est précédée d'une étape 101 optionnelle de détermination d'une durée T de bombardement ionique pour obtenir la seconde coloration dans la première zone prédéterminée Z1.

Selon encore un autre exemple la réduction d'épaisseur et de la couche interférentielle éloignée M1 est déterminée tel que l'article optique miroité 1 présente par un phénomène d'interférométrie un miroitage ayant une intensité de réflexion dans la première zone prédéterminée Z1 différente d'une zone non traitée par le bombardement ionique.

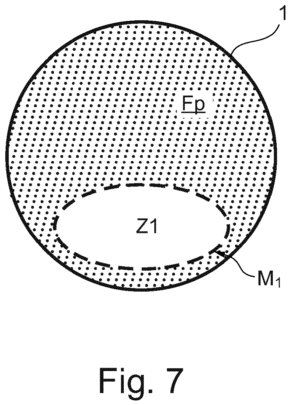

Selon la figure 7 qui est une variante de la figure 4, l'article optique miroité comprend ladite première zone prédéterminée Z1 et une zone non traitée par le bombardement ionique, protégée par le film de protection Fp, et l'une des deux zones, ici la zone Z1, correspond à une zone de vision de près avec un miroitage ayant une intensité de réflexion plus faible que dans l'autre zone (la zone non traitée) correspondant à une vision de loin.

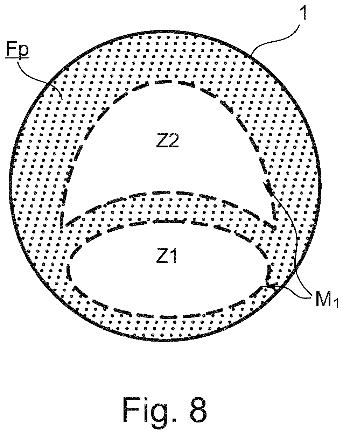

Selon une autre variante montrée en figure 8 dans lequel la surface de la première zone prédéterminée Z1 est plus petite que la surface de l'article optique miroité 1, le procédé peut comporter en outre une deuxième étape d'enlèvement 105 par bombardement ionique au moins dans une deuxième zone prédéterminée Z2 de l'article optique miroité 1 qui est différente de la première zone prédéterminée Z1. Lors de cette deuxième étape d'enlèvement 105, la zone Z1 peut être protégée, par exemple par un film adhésif Fp supplémentaire, et une deuxième épaisseur prédéfinie de la couche interférentielle éloignée M1 est enlevée qui est inférieure à la première épaisseur initiale de cette couche interférentielle éloignée et différente de l'épaisseur enlevée lors de la première étape d'enlèvement 103. Il en résulte que dans la deuxième zone prédéterminée Z2, l'article optique miroité 1 présente par un phénomène d'interférométrie une troisième coloration selon l'espace CIELAB différente de la première et de la deuxième coloration selon l'espace CIELAB. On obtient donc un article optique miroité tricolore.

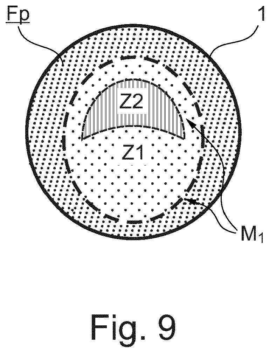

Selon encore une autre variante montrée en figure 9, dans lequel la surface de la première zone prédéterminée Z1 est plus petite que la surface de l'article optique miroité 1, le procédé peut comporter en outre une deuxième étape 105 d'enlèvement par bombardement ionique au moins dans une deuxième zone prédéterminée Z2 de l'article optique miroité 1 qui est incluse dans la première zone prédéterminée Z1 et plus petite que cette dernière.

Lors de la deuxième étape d'enlèvement 105, un film de protection adhésif Fp protège tout l'article optique miroité sauf la zone prédéterminée Z2 et une deuxième épaisseur prédéfinie de la couche interférentielle éloignée M1 est enlevée qui est inférieure à la différence entre la première épaisseur initiale de cette couche interférentielle éloignée et l'épaisseur enlevée lors de la première étape d'enlèvement. Dans la deuxième zone prédéterminée, l'article optique miroité 1 présente en conséquence par un phénomène d'interférométrie une troisième coloration selon l'espace CIELAB différente de la première et de la deuxième coloration selon l'espace CIELAB.

On comprend donc que le procédé de traitement de l'article optique miroité 1 permet de changer de façon précise et répétable certains paramètres, notamment la coloration pour obtenir un produit personnalisé avec un cout de revient contenu.

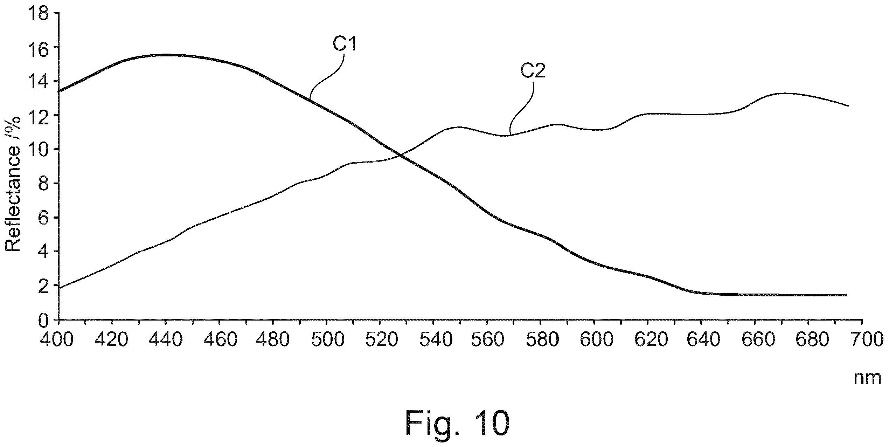

La figure 10 montre par exemple la réflectivité en fonction de la longueur d'onde d'un article optique miroité 1 dans la zone prédéterminé Z1 avant, courbe C1, et après, courbe C2, l'étape 103 du procédé de traitement. Avant le traitement selon l'étape 103, l'article optique miroité 1 présente dans son ensemble et plus spécifiquement dans la zone prédéterminée Z1 un aspect « bleu », tandis qu'après traitement, la zone prédéterminée Z1 présente un aspect « bronze » comme le montrent les spectres de la figure 10. A partir d'un article optique miroité 1 d'une couleur prédéterminée, on aboutit à un article optique miroité d'une autre couleur ou présentant deux, voire trois couleurs différentes. Selon des exemples, le changement de coloration peut être moins prononcé et se traduire par exemple par un effet « pastel ».

Par ailleurs, par inspection d'un article optique miroité traité selon le procédé décrit ci-dessus notamment à l'aide d'un microscope électronique, on peut observer que l'enlèvement dans une zone prédéterminée d'une épaisseur de l'empilement miroité est réalisé par bombardement ionique. En particulier, dans une zone prédéterminée Z1 par exemple, on peut observer localement une densification des couches ayant subi le bombardement ionique par rapport à une zone où les couches n'ont pas subi de bombardement ionique.

**Revendications**

1. Procédé de traitement d'une lentille ophtalmique miroitée comprenant :

   - un substrat (10),
   - un empilement (21) de miroitage d'au moins deux couches interférentielles (M1 à M6) porté par le substrat (10) augmentant ainsi la réflexion et présentant :

      * une couche interférentielle éloignée (M1) du substrat (10), avec une première épaisseur initiale et un premier indice de réfraction et
      * au moins une couche interférentielle (M2) rapprochée disposée entre le substrat (10) et la couche interférentielle éloignée (M1), avec une seconde épaisseur et un second indice de réfraction différent du premier indice de réfraction, l'empilement de miroitage (21) donnant par un phénomène d'interférométrie une première coloration selon l'espace CIELAB à la lentille ophtalmique miroitée (1),

   le procédé comportant une étape (103) d'enlèvement par bombardement ionique au moins dans une première zone (Z1) prédéterminée d'une épaisseur de l'empilement miroité qui est inférieure à la somme des épaisseurs initiales concernées par l'étape d'enlèvement, la lentille ophtalmique miroitée présentant par un phénomène d'interférométrie une deuxième coloration selon l'espace CIELAB différente de la première coloration.

2. Procédé selon la revendication 1, dans lequel lors de l'étape (103) d'enlèvement par bombardement ionique, l'épaisseur initiale de la couche interférentielle éloignée est réduite d'une valeur inférieure à son épaisseur initiale.

3. Procédé selon la revendication 2, dans lequel l'empilement de miroitage (21) comporte deux (M1, M2) ou au moins trois couches interférentielles (M1 à M6), et dans lequel la réduction d'épaisseur de la couche interférentielle éloignée est déterminée de façon à ce qu'entre la première et la seconde coloration, la différence de l'angle de teinte est inférieure à 2% et la différence de la chromacité est supérieure à 10%.

4. Procédé selon la revendication 2 ou 3, dans lequel la différence de brillance entre la première et la seconde coloration est inférieure à 10%, notamment inférieur à 5%.

5. Procédé selon l'une quelconque des revendications 2, 3 ou 4, dans lequel entre la première et la seconde coloration, le rapport b*/a* de l'espace CIELAB est constant dans la limite d'une tolérance de 10%, notamment 5%.

6. Procédé selon l'une des revendications précédentes dans lequel la réduction d'épaisseur est uniforme dans chacune des zones prédéterminées.

7. Procédé selon l'une des revendications précédentes dans lequel l'étape d'enlèvement par bombardement ionique est précédée d'une étape (101) de détermination d'une durée de bombardement ionique pour obtenir la seconde coloration dans la première zone prédéterminée.

8. Procédé selon l'une des revendications précédentes, dans lequel l'étape d'enlèvement par bombardement ionique est tel que la lentille ophtalmique miroitée présente par un phénomène d'interférométrie un miroitage ayant une intensité de réflexion dans la première zone prédéterminée différente d'une zone non traitée par le bombardement ionique.

9. Procédé selon l'une des revendications précédentes, dans lequel la lentille ophtalmique miroitée comprend ladite première zone prédéterminée et une zone non traitée par le bombardement ionique, l'une des deux zones correspondant à une zone de vision de près (Z1) avec un miroitage ayant une intensité de réflexion plus faible que dans l'autre zone correspondant à une vision de loin.

10. Procédé selon la revendication l'une quelconque des revendications 1 à 9, dans lequel la surface de la première zone prédéterminée est plus petite que la surface de l'article optique miroité et dans lequel le procédé comporte en outre une deuxième étape d'enlèvement par bombardement ionique au moins dans une deuxième zone prédéterminée (Z2) de l'article optique miroité (1) qui est différente de la première zone prédéterminée, lors de la deuxième étape d'enlèvement une deuxième épaisseur prédéfinie de la couche interférentielle éloigné est enlevée qui est inférieure à la première épaisseur initiale de cette couche interférentielle éloignée et différente de l'épaisseur enlevée lors de la première étape d'enlèvement, dans la deuxième zone prédéterminée, la lentille ophtalmique miroitée (1) présentant par un phénomène d'interférométrie une troisième coloration selon l'espace CIELAB différente de la première et de la deuxième coloration selon l'espace CIELAB.

11. Procédé selon l'une quelconque des revendications 1 à 10, dans lequel on dispose un masque entre la lentille ophtalmique miroitée et un canon à ions empêchant les ions à parvenir aux couches interférentielles en dehors de la zone prédéterminée.

12. Procédé selon l'une quelconque des revendications 1 à 11, dans lequel on réalise le bombardement ionique sous vide, ou dans une atmosphère contenant un gaz inerte ayant une pression inférieure ou égale à la pression atmosphérique.

13. Procédé selon l'une quelconque des revendications 1 à 12, dans lequel après l'étape d'enlèvement par bombardement ionique, on applique un traitement antisalissure sur l'ensemble de la lentille ophtalmique miroitée.

14. Lentille ophtalmique miroitée (1) obtenue avec un procédé selon l'une quelconque des revendications 1 à 13 et présentant au moins deux colorations différentes selon l'espace CIELAB.

15. Lentille ophtalmique miroitée selon la revendication 14, dans lequel l'article miroité comprend ladite première zone prédéterminée (Z1) et une zone non traitée par le bombardement ionique, l'une des deux zones correspondant à une zone de vision de près avec un miroitage ayant une intensité de réflexion plus faible que dans l'autre zone correspondant à une vision de loin.

**Patentansprüche**

1. Verfahren zur Behandlung einer verspiegelten ophthalmischen Linse, die umfasst:

    - ein Substrat (10),
    - ein Verspiegelungsschichtsystem (21) aus mindestens zwei Interferenzschichten (M1 bis M6), das von dem Substrat (10) getragen wird und das somit die Reflexion erhöht und aufweist:

        * eine von dem Substrat (10) entfernte Interferenzschicht (M1) mit einer ersten Ausgangsdicke und einem ersten Brechungsindex und
        * mindestens eine zwischen dem Substrat (10) und der entfernten Interferenzschicht (M1) angeordnete nahe Interferenzschicht (M2) mit einer zweiten Dicke und einem zweiten Brechungsindex, der von dem ersten Brechungsindex verschieden ist, wobei das Verspiegelungsschichtsystem (21) durch ein Interferometriephänomen eine erste Tönung gemäß dem CIELAB-Raum für die verspiegelte ophthalmische Linse (1) ergibt, wobei das Verfahren einen Schritt (103) des Abtragens durch Ionenbeschuss mindestens in einem ersten vorbestimmten Bereich (Z1) einer Dicke des verspiegelten Schichtsystems umfasst, die geringer als die Summe der von dem Schritt des Abtragens betroffenen Ausgangsdicken ist, wobei die verspiegelte ophthalmische Linse durch ein Interferometriephänomen eine zweite Tönung gemäß dem CIELAB-Raum aufweist, die von der ersten Tönung verschieden ist.

2. Verfahren nach Anspruch 1, wobei bei dem Schritt (103) des Abtragens durch Ionenbeschuss die Ausgangsdicke der entfernten Interferenzschicht um einen Wert verringert wird, der geringer als ihre Ausgangsdicke ist.

3. Verfahren nach Anspruch 2, wobei das Verspiegelungsschichtsystem (21) zwei (M1, M2) oder mindestens drei Interferenzschichten (M1 bis M6) umfasst und wobei die Dickenverringerung der entfernten Interferenzschicht so bestimmt wird, dass zwischen der ersten und der zweiten Tönung die Differenz des Farbwinkels kleiner als 2 % ist und die Differenz der Buntheit größer als 10 % ist.

4. Verfahren nach Anspruch 2 oder 3, wobei die Sättigungsdifferenz zwischen der ersten und der zweiten Tönung kleiner als 10 %, insbesondere kleiner als 5 % ist.

5. Verfahren nach einem der Ansprüche 2, 3 oder 4, wobei zwischen der ersten und der zweiten Tönung das Verhältnis b*/a* des CIELAB-Raums innerhalb der Grenze einer Toleranz von 10 %, insbesondere 5 %, konstant ist.

6. Verfahren nach einem der vorhergehenden Ansprüche, wobei die Dickenverringerung in jedem der vorbestimmten Bereiche einheitlich ist.

7. Verfahren nach einem der vorhergehenden Ansprüche, wobei dem Schritt des Abtragens durch Ionenbeschuss ein Schritt (101) des Bestimmens einer Ionenbeschussdauer zum Erhalten der zweiten Tönung in dem ersten vorbestimmten Bereich vorausgeht.

8. Verfahren nach einem der vorhergehenden Ansprüche, wobei der Schritt des Abtragens durch Ionenbeschuss dergestalt ist, dass die verspiegelte ophthalmische Linse durch ein Interferometriephänomen eine Verspiegelung aufweist, die eine Reflexionsintensität in dem ersten vorbestimmten Bereich hat, die verschieden von einem nicht durch den Ionenbeschuss behandelten Bereich ist.

9. Verfahren nach einem der vorhergehenden Ansprüche, wobei die verspiegelte ophthalmische Linse den ersten vorbestimmten Bereich und einen nicht durch den Ionenbeschuss behandelten Bereich umfasst, wobei einer der beiden Bereiche einem Nahsichtbereich (Z1) mit einer Verspiegelung entspricht, die eine geringere Reflexionsintensität hat als in dem anderen Bereich, der einer Fernsicht entspricht.

10. Verfahren nach Anspruch einem der Ansprüche 1 bis 9, wobei die Fläche des ersten vorbestimmten Bereichs kleiner ist als die Fläche des verspiegelten optischen Artikels und wobei das Verfahren ferner einen zweiten Schritt des Abtragens durch Ionenbeschuss mindestens in einem zweiten vorbestimmten Bereich (Z2) des verspiegelten optischen Artikels (1) umfasst, der verschieden von dem ersten vorbestimmten Bereich ist, wobei bei dem zweiten Schritt des Abtragens eine zweite vorgegebene Dicke der entfernten Interferenzschicht abgetragen wird, die geringer als die erste Ausgangsdicke dieser entfernten Interferenzschicht ist und verschieden von der bei dem ersten Schritt des Abtragens abgetragenen Dicke ist, in dem zweiten vorbestimmten Bereich, wobei die verspiegelte ophthalmische Linse (1) durch ein Interferometriephänomen eine dritte Tönung gemäß dem CIELAB-Raum aufweist, die verschieden von der ersten und der zweiten Tönung gemäß dem CIELAB-Raum ist.

11. Verfahren nach einem der Ansprüche 1 bis 10, wobei eine Maske zwischen der verspiegelten ophthalmischen Linse und einer Ionenkanone angeordnet wird, welche die Ionen daran hindert, zu den Interferenzschichten außerhalb des vorbestimmten Bereichs zu gelangen.

12. Verfahren nach einem der Ansprüche 1 bis 11, wobei der Ionenbeschuss unter Vakuum ausgeführt wird oder in einer Atmosphäre, die ein inertes Gas enthält, das einen Druck hat, der kleiner oder gleich dem atmosphärischen Druck ist.

13. Verfahren nach einem der Ansprüche 1 bis 12, wobei nach dem Schritt des Abtragens durch Ionenbeschuss eine Schmutzabweisungsbehandlung auf die gesamte verspiegelte ophthalmische Linse appliziert wird.

14. Verspiegelte ophthalmische Linse (1), die mit einem Verfahren nach einem der Ansprüche 1 bis 13 erhalten wird und mindestens zwei verschiedene Tönungen gemäß dem CIELAB-Raum aufweist.

15. Verspiegelte ophthalmische Linse nach Anspruch 14, wobei der verspiegelte Artikel den ersten vorbestimmten Bereich (Z1) und einen nicht durch den Ionenbeschuss behandelten Bereich umfasst, wobei einer der beiden Bereiche einem Nahsichtbereich mit einer Verspiegelung entspricht, die eine geringere Reflexionsintensität als in dem anderen Bereich hat, der einer Fernsicht entspricht.

## Claims

1. Process for treating a mirror-effect ophthalmic lens comprising:

   - a substrate (10),
   - a mirror stack (21) of at least two interferential layers (M1 to M6) borne by the substrate (10) thus increasing reflectance and having:

* an interferential layer (M1) far from the substrate (10), with a first initial thickness and a first refractive index, and

* at least one near interferential layer (M2) placed between the substrate (10) and the far interferential layer (M1), with a second thickness and a second refractive index which is different from the first refractive index, the mirror stack (21) giving, via an interference effect, a first colour in the CIELAB space to the mirror-effect ophthalmic lens (1), the process comprising a step (103) of removing, via ion bombardment, at least from a first predetermined region (Z1), a mirror-stack thickness that is smaller than the sum of the initial thicknesses concerned by the removing step, the mirror-effect ophthalmic lens exhibiting, via an interference effect, a second colour in the CIELAB space which is different from the first colour.

2. Process according to Claim 1, wherein, in the step (103) of removing via ion bombardment, the initial thickness of the far interferential layer is decreased by a value smaller than its initial thickness.

3. Process according to Claim 2, wherein the mirror stack (21) comprises two (M1, M2) or at least three interferential layers (M1 to M6), and wherein the decrease in thickness of the far interferential layer is determined so that, between the first and second colours, the difference in hue angle is smaller than 2% and the difference in chroma is larger than 10%.

4. Process according to Claim 2 or 3, wherein the difference in lightness between the first and second colours is smaller than 10%, and especially smaller than 5%.

5. Process according to any one of Claims 2, 3 and 4, wherein, between the first and second colours, the b*/a* ratio in the CIELAB space is constant within a tolerance of 10%, and especially of 5%.

6. Process according to one of the preceding claims, wherein the decrease in thickness is uniform in each of the predetermined regions.

7. Process according to one of the preceding claims, wherein the step of removing via ion bombardment is preceded by a step (101) of determining an ion-bombardment time required to obtain the second colour in the first predetermined region.

8. Process according to one of the preceding claims, wherein the step of removing via ion bombardment is such that the mirror-effect ophthalmic lens exhibits, via an interference effect, a mirror effect having a reflectance in the first predetermined region different from a region not treated by the ion bombardment.

9. Process according to one of the preceding claims, wherein the mirror-effect ophthalmic lens comprises said first predetermined region and a region not treated by the ion bombardment, one of the two regions corresponding to a near-vision region (Z1) with a mirror effect having a reflectance lower than in the other region, which corresponds to a far-vision region.

10. Process according to Claim any one of Claims 1 to 9, wherein the area of the first predetermined region is smaller than the area of the mirror-effect optical article and wherein the process further comprises a second step of removing via ion bombardment, at least from a second predetermined region (Z2) of the mirror-effect optical article (1) that is different from the first predetermined region, in the second removing step, a second predefined thickness of the far interferential layer is removed that is smaller than the first initial thickness of this far interferential layer and different from the thickness removed, in the first removing step, from the second predetermined region, the mirror-effect ophthalmic lens (1) exhibiting, via an interference effect, a third colour in the CIELAB space different from the first and second colours in the CIELAB space.

11. Process according to any one of Claims 1 to 10, wherein a mask is placed between the mirror-effect ophthalmic lens and an ion gun, preventing ions from reaching the interferential layers outside of the predetermined region.

12. Process according to any one of Claims 1 to 11, wherein the ion bombardment is carried out under vacuum conditions, or in an atmosphere containing an inert gas having a pressure lower than or equal to atmospheric pressure.

13. Process according to any one of Claims 1 to 12, wherein, after the step of removing via ion bombardment, an anti-smudge treatment is applied to the entirety of the mirror-effect ophthalmic lens.

14. Mirror-effect ophthalmic lens (1) obtained by a process according to any one of Claims 1 to 13 and exhibiting at least two different colours in the CIELAB space.

15. Mirror-effect ophthalmic lens according to Claim 14, wherein the mirror-effect article comprises said first predetermined region (Z1) and a region not treated by the ion bombardment, one of the two regions corresponding to a near-vision region with a mirror effect having a reflectance lower than in the other region, which corresponds to a far-vision region.

Fig. 1A

[Fig 1B]

FIG. 1B

Fig. 2

5

1

| M1 |
| M2 |
| M3 |
| M4 |
| M5 |
| M6 |

21

35

10

Fig. 3

Fig. 4

Fig. 5

Fig. 6

Fig. 7

Fig. 8

Fig. 9

Fig. 10

EP 4 127 786 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2018015650 A
- DE 102011119598

- US 2005084626 A
- US 2019302697 A